(19) Europäisches Patentamt
European Patent Office
Office européen des brevets

(11) **EP 2 244 383 A1**

(12) **EUROPEAN PATENT APPLICATION**

(43) Date of publication:
**27.10.2010 Bulletin 2010/43**

(51) Int Cl.:
*H03K 17/082* (2006.01)   *H02M 5/458* (2006.01)
*H02M 7/217* (2006.01)

(21) Application number: **09158624.8**

(22) Date of filing: **23.04.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicants:
• **Mitsubishi Electric R&D Centre Europe B.V.**
  **1119 NS Schiphol Rijk (NL)**
  Designated Contracting States:
  **FR**
• **Mitsubishi Electric Corporation**
  **Tokyo 100-8310 (JP)**
  Designated Contracting States:
  **AT BE BG CH LI CY CZ DE DK EE ES FI GB GR HR HU IE IS IT LT LU LV MC MK MT NL NO PL PT RO SE SI SK TR**

(72) Inventors:
• **Buiatti, Gustavo**
  **35708 Rennes Cedex 7 (FR)**
• **Voyer, Nicolas**
  **35708 Rennes Cedex 7 (FR)**

(74) Representative: **Maillet, Alain**
  **Cabinet Le Guen Maillet**
  **5 Place Newquay**
  **B.P. 70250**
  **35802 Dinard Cedex (FR)**

(54) **Method and apparatus for controlling the operation of a snubber circuit**

(57)   The present invention concerns an apparatus for controlling the operation of a snubber circuit in a system in which an input voltage is processed using at least switches controlled with at least one periodical pattern. The input voltage is applied to the snubber circuit when the operation of the snubber circuit is enabled. The apparatus comprises:
- means for determining a periodical pattern to be used for controlling the switches, the periodical pattern modifying the input voltage,
- means for disabling the operation of the snubber circuit,
- means for controlling the switches with the determined periodical pattern,
- means for checking if the input voltage is compatible with a given value,
- means for enabling the operation of the snubber circuit when the input voltage is compatible with the given value.

Fig. 6

**Description**

The present invention relates generally to a method and an apparatus for controlling the operation of a snubber circuit.

Snubber circuits are frequently used in electrical systems with an inductive load where the sudden interruption of current flow often leads to a sharp rise in voltage across the device creating the interruption. This sharp rise in voltage is a transient and can damage and lead to the failure of the semiconductor device. A spark is likely to be generated (arcing) and to cause electromagnetic interference. The snubber circuit prevents this undesired voltage by conducting transient current around the device. A simple snubber comprising a small resistor $R_S$ in series with a small capacitor $C_S$ is often used. Thus, the snubber circuit protects power devices against voltage breakdowns and also avoids electromagnetic interferences in order to comply with some rules and standards.

Snubber circuits are often used in DC/DC converters. Classical DC/DC converters use inductors in order to convert a direct current from a first voltage to a second voltage which may be larger or smaller than the first voltage.

Inductors are used for storing energy in the form of magnetic field (current) and they have many drawbacks. Inductors are heavy, their cost is relatively important because they are mainly composed of copper material.

The combination of switches and capacitors in order to replace inductors has been already proposed.

For example, charge pumps, also known as DC/DC converters use capacitors as energy storage elements. When compared to inductive switching DC/DC converters, which also use inductors as energy storage elements, charge pumps offer unique characteristics that make them attractive for certain end-user applications.

Basically, the inductor of the conventional DC/DC Boost converter is replaced by "k" bridge devices connected in series, each bridge device is composed of four switches and a capacitor.

The voltage on each bridge may be positive, null or negative according to the control of the switches. Dead-time needs to be applied between switching of the high side and low side switches of each bridge leg in order to avoid that the bridge capacitors may be short circuited.

However, the dead-time may lead to some drawbacks, such as high voltage overshoots that appear on the switches. These overshoots will also appear in the input of the boost converter composed of plural bridge devices several times within a single switching period which is usually up to $2^k$ times, where k is the number of bridge devices. In the case of a photovoltaic module connected to the boost converter composed of plural bridge devices as the power source, the input voltage variations are even more undesirable as there may represent loss of power generation due to the oscillations around the maximum power point (MPP) of the photovoltaic module.

Snubber circuits avoid voltage overshoots and protect the switches.

In the special case of a photovoltaic module connected to the boost converter composed of plural bridge devices, snubber circuit avoid voltage overshoots and the consequent power generation losses around the MPP.

Boost convertors composed of plural bridge devices can only achieve some discrete values of voltage step-up ratio (and consequently of values of duty-cycles D, where ratio = 1/(1-D)), which are dependent on the number of available bridges.

Periodical switching patterns are selected in order to provide different boost ratios. When the input voltage varies, it is sometimes necessary to select another switching pattern which provides another boost ratio.

By changing the boost ratio, the input voltage of the photovoltaic module may vary during a certain time voltage levels which exist on each bridge capacitor for each duty-cycle case at equilibrium condition may be different between different boost ratios.

During this transient time, the snubber circuit of the boost converter composed of plural bridge devices has to cope with such input voltage variation and large current peaks can be generated if the voltage imposed by the boost converter composed of plural bridge devices in the input is smaller than the voltage level on the snubber capacitor.

The components of snubber circuits need then to be sized in order to cope with the large current peaks.

The overall cost of the boost converter composed of plural bridge devices is then increased.

Additional power losses are added to the inductor boost less converter and its components may be damaged by the larger current peaks.

The present invention aims at providing a method and an apparatus which provide the advantages of snubber circuits in normal operation conditions for a given duty-cycle, without the need of a snubber circuit which is able to withstand high currents.

To that end, the present invention concerns an apparatus for controlling the operation of a snubber circuit in a system in which an input voltage is processed using at least switches controlled with at least one periodical pattern, **characterised in that** the input voltage is applied to the snubber circuit when the operation of the snubber circuit is enabled, and in that the apparatus comprises:

- means for determining a periodical pattern to be used for controlling the switches, the periodical pattern modifying the input voltage,

- means for disabling the operation of the snubber circuit,
- means for controlling the switches with the determined periodical pattern,
- means for checking if the input voltage is compatible with a given value,
- means for enabling the operation of the snubber circuit when the input voltage is compatible with the given value.

The present invention concerns also a method for controlling the operation of a snubber circuit in a system in which an input voltage is processed using at least switches using at least one periodical pattern, **characterised in that** the input voltage is applied to the snubber circuit when the operation of the snubber circuit is enabled, and in that the method comprises the steps of:

- determining a periodical pattern to be used for controlling the switches, the periodical pattern modifying the input voltage,
- disabling the operation of the snubber circuit,
- controlling the switches with the determined periodical pattern,
- checking if the input voltage is compatible with a given value,
- enabling the operation of the snubber circuit when the input voltage is compatible with the given value.

Thus, it is not necessary to have snubber circuits which are able to operate with high currents.

According to a particular feature, the switches used for processing the input voltage are switches of a boost converter composed of plural bridge devices.

Thus, it is possible to obtain constant output voltage by changing the boost converter composed of plural bridge devices duty-cycle through the associated switching pattern.

According to a particular feature, the means for enabling/disabling the operation of the snubber circuit are composed of a switch.

Thus, the snubber circuit can be continuously connected to the boost converter composed of plural bridge devices, except for the moments in which high current could be generated due to its presence such as during the converter start-up and also during the duty-cycles changes.

According to a particular feature, the means for enabling/disabling the operation of the snubber circuit are composed of two N-MOSFET transistors and their respective body diodes, connected in series and in opposite position.

Thus, undesirable current that could flow through the N-MOSFET body diode is avoided at all, the current flowing through the two N-MOSFETS is only allowed if both of them are enabled (ON state).

According to a particular feature, the anode of a first diode is connected to the source of a first N-MOSFET transistor $S_{WS1}$, the cathode of the first diode is connected to the drain of the first N-MOSFET transistor, the anode of a second diode is connected to the source of a second N-MOSFET transistor and the cathode of the second diode is connected to the drain of the second N-MOSFET transistor $S_{WS}$ and the drain of the first N-MOSFET transistor $S_{WS1}$ is connected to the drain of the second N-MOSFET transistor.

According to a particular feature, the snubber circuit is composed of a capacitor connected in series with a sub-circuit composed of a resistor and a diode connected in parallel.

Thus, it is possible to control the voltage rise required for a given time duration avoiding undesirable large voltage variations around an average voltage value such as the MPP of a photovoltaic module.

The characteristics of the invention will emerge more clearly from a reading of the following description of an example embodiment, the said description being produced with reference to the accompanying drawings, among which :

Fig. 1 is an example of a boost converter composed of three bridge devices in which the present invention is implemented;
Fig. 2 represents an example of a switch for disconnecting or not the snubber circuit ;
Fig. 3 represents an example of a device comprising a boost converter composed of plural bridge devices;
Fig. 4 is an example of voltage values on the bridges of the boost converter composed of three bridges in order to have a first step-up ratio when the periodical pattern is decomposed into eight time intervals;
Fig. 5 is an example of voltage values on the bridges of the boost converter composed of three bridges in order to have a second step-up ratio when the periodical pattern is decomposed into seven time intervals;
Fig. 6 is an example of an algorithm for controlling the connection or not of the snubber circuit to the boost converter composed of plural bridge devices according to the present invention.

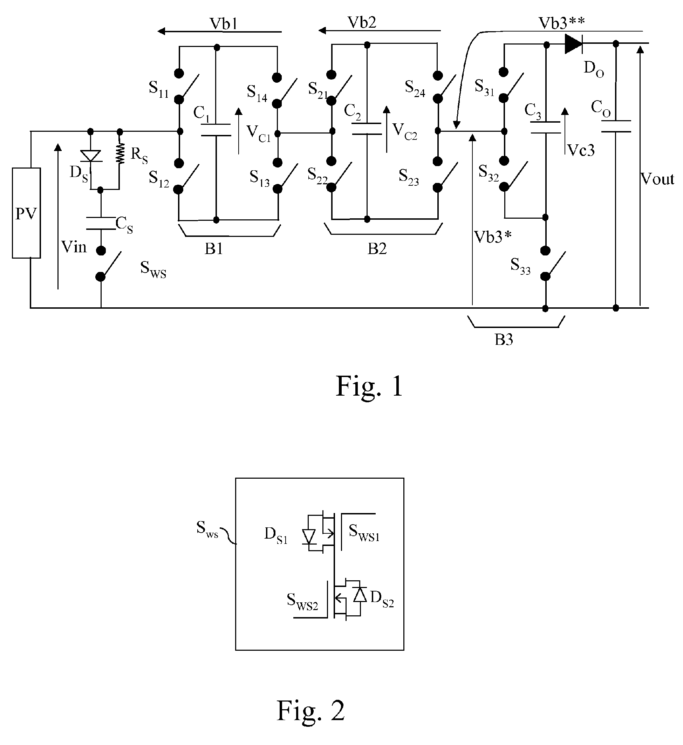

**Fig. 1** is an example of a boost converter composed of three bridge devices in which the present invention is implemented.

The boost converter is also named Reactor Less Boost Converter or an inductor less boost converter, herein named RLBC.

The present invention is described in a RLBC connected to a photovoltaic module. The present application is also applicable in any system wherein input voltage may vary and wherein switches and capacitors are used.

Basically, the inductor of the conventional DC/DC Boost converter is replaced by "k" bridge devices connected in series. Each bridge device is composed of four switches and a capacitor as shown in Fig. 1. It has to be noted here that two switches may be under the form of diodes acting as switches. This individual bridge structure is also named "bit". The boost converter composed of plural bridge devices also contains an output stage comprising a diode Do and a capacitor Co.

In the Fig. 1, three bits or bridge devices B1, B2 and B3 are shown and are connected in series; the third bit B3 is connected to the output stage.

A boost converter comprising a more important number of bridge devices can be obtained by duplicating the bit B1 as much as necessary.

The bit B1 is composed of four switches $S_{11}$, $S_{12}$, $S_{13}$ and $S_{14}$ and one capacitor $C_1$.

The switches $S_{11}$ and $S_{14}$ are the switches of the high side of the bit B1 and the switches $S_{12}$ and $S_{13}$ are the switches of the low side of the bit B1.

The switches $S_{11}$ and $S_{12}$ are the switches of one leg of the bit B1 and the switches $S_{14}$ and $S_{13}$ are the switches of the other leg of the bit B1.

The bit B2 is composed of four switches $S_{21}$, $S_{22}$, $S_{23}$ and $S_{24}$ and one capacitor $C_2$.

The switches $S_{21}$ and $S_{24}$ are the switches of the high side of the bit B2 and the switches $S_{22}$ and $S_{23}$ are the switches of the low side of the bit B2.

The switches $S_{21}$ and $S_{22}$ are the switches of one leg of the bit B2 and the switches $S_{24}$ and $S_{23}$ are the switches of the other leg of the bit B2.

The bit B3 is composed of three switches $S_{31}$, $S_{32}$ and $S_{33}$ and one capacitor $C_3$.

For each bit Bi with i=1 or 2, the first terminal of the switch $S_{i1}$ is connected to the second terminal of the switch $S_{i2}$. The second terminal of the switch $S_{i1}$ is connected to the second terminal of the switch $S_{i4}$ and to the positive terminal of the capacitor $C_i$. The first terminal of the switch $S_{i2}$ is connected to the negative terminal of the capacitor $C_i$ and to the first terminal of the switch $S_{i3}$. The first terminal of the switch $S_{i4}$ is connected to the second terminal of the switch $S_{i3}$.

Electric DC providing means like photovoltaic modules provide an input voltage Vin. The positive terminal of electric DC providing means is connected to the first terminal of the switch $S_{11}$.

For the bit B3, the first terminal of the switch $S_{31}$ is connected to the second terminal of the switch $S_{32}$. The second terminal of the switch $S_{31}$ is connected to anode of the diode Do and to the positive terminal of the capacitor $C_3$. The first terminal of the switch $S_{32}$ is connected to the negative terminal of the capacitor $C_3$ and to the second terminal of the switch $S_{33}$. The first terminal of the switch $S_{33}$ is connected to the negative terminal of electric DC providing means.

The cathode of the diode Do is connected to the positive terminal of the capacitor $C_o$. The negative terminal of the capacitor $C_O$ is connected to the negative terminal of electric DC providing means.

The first terminal of the switch $S_{14}$ is connected to the first terminal of the switch $S_{21}$.

The first terminal of the switch $S_{24}$ is connected to the first terminal of the switch $S_{31}$.

The voltage on the capacitor $C_O$ is equal to Vout.

The difference of voltage between the input and the output of B1 is named Vb1, the difference of voltage between the input and the output of B2 is named Vb2 and the difference of voltage between the input and the output of B3 is named Vb3. Vb3 equals Vb3* when switch $S_{33}$ is on, and equals Vb3** when switch $S_{33}$ is off.

The difference of voltage in $C_1$ is named $V_{C1}$, the difference of voltage in $C_2$ is named $V_{C2}$ and the difference of voltage in $C_3$ is named $V_{C3}$.

The RLBC further comprises a snubber circuit.

The snubber circuit is composed of a diode $D_S$, a resistor $R_S$ and a capacitor $C_S$.

The positive terminal of electric DC providing means is connected to the anode of the diode $D_S$ and to the first terminal of the resistor $R_S$. The cathode of the diode $D_S$ is connected to the second terminal of the resistor $R_S$ and to a first terminal of the capacitor $C_S$.

According to the invention, a switch is provided in the present invention for enabling or disabling the operation of the snubber circuit.

The second terminal of the capacitor $C_S$ is connected to the first terminal of the switch $S_{WS}$. The second terminal of the switch $S_{WS}$ is connected to the negative terminal of electric DC providing means.

The main difference between conventional Boost converters and the RLBC relies on the fact that the latter can only achieve some discrete values of voltage step-up ratio (and consequently of values of duty-cycles D, where ratio = 1/(1-D)), which are dependent on the number of available "bits".

In operation, RLBC provides discrete values of voltage step-up ratio which are dependent on the number of available "bits". This number of discrete values of step-up ratio may respect the law:

$$n_{ratios}=2^k$$

where "$n_{ratios}$" is the total number of possible step-up ratios (or duty-cycles) and "k" is the number of bits connected in series.

The voltage values imposed in each bit may respect the following law:

$$[Vc1 : Vc2 : ... : Vcn] = [1 : 2 : ... 2^{(k-1)}] V_{CO} / 2^k$$

where $V_{CO}$ is the stepped-up output voltage.

For obtaining a constant output voltage, it is possible to have "$n_{ratios}$" different input voltages, which will respect the following law:

$$Vin = V_{CO} / ratio_i , i=1,2,...n_{ratios}$$

For the case n=3 bits of Fig. 1, [Vc1:Vc2:Vc3] = [1:2:4]Vref.

The switching pattern of the switches of each bridge Bi is defined so as to offer a voltage Vbi at the connectors of the bridge that equals + Vci, -Vci, or 0, where Vci is the voltage of the capacitor $C_i$. Moreover, the switching pattern of each bit Bi is timely defined as a succession of $2^k$ equal sub periods $\Delta T$ of the main switching period T = 1/f.

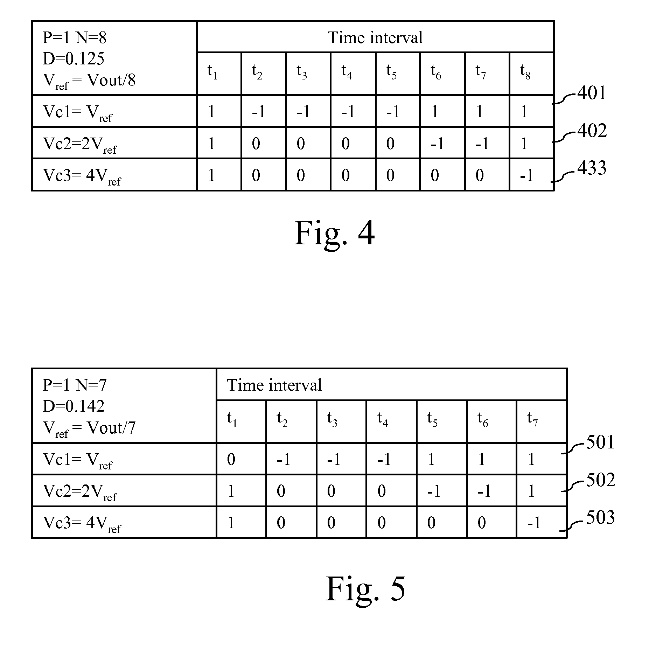

An example of voltage values on the bridges of the boost converter composed of three bridge devices will be described in reference to the Figs. 4 or 5.

It has to be noted here that other configurations like [Vc1:Vc2:Vc3] = [2:3:4] or [Vc1:Vc2:Vc3:Vc3] = [1:1:1:4] may be used. Furthermore, $n_{ratios}$ can finally be higher than $2^k$

The switching patterns are applied on the switches $S_{11}$, $S_{12}$, $S_{13}$, $S_{14}$, $S_{21}$, $S_{22}$, $S_{23}$, $S_{245}$ $S_{315}$ $S_{32}$ and $S_{33}$.

The operation of a snubber circuit in a system in which an input voltage is processed using at least switches controlled with at least one periodical pattern is controlled. The input voltage is applied to the snubber circuit when the operation of snubber circuit is enabled.

According to the invention, a periodical pattern to be used for controlling the switches is determined, the periodical pattern boosting the input voltage and which will cause some modification on the input voltage value during the transient state. During the transient state, the operation of the snubber circuit is disabled, the switches are controlled with the determined periodical pattern and it is checked if the transient state is over and the input voltage is stable. The operation of the snubber circuit is enabled if the input voltage is compatible with a given value.

**Fig. 2** represents an example of a switch for disconnecting or not the snubber circuit.

The switch $S_{WS}$ is for example composed of two N-MOSFET transistors and their respective body diodes. The anode of the body diode $D_{S1}$ is connected to the source of the N-MOSFET transistor $S_{WS1}$ and the cathode of the body diode $D_{S1}$ is connected to the drain of the N-MOSFET transistor $S_{WS1}$.

The anode of the body diode $D_{S2}$ is connected to the source of the N-MOSFET transistor $S_{WS2}$ and the cathode of the body diode $D_{S2}$ is connected to the drain of the N-MOSFET transistor $S_{WS2}$.

The drain of the N-MOSFET transistor $S_{WS1}$ is connected to the drain of the N-MOSFET transistor $S_{WS2}$. The source of the N-MOSFET transistor $S_{WS2}$ is connected to the negative terminal of the electric DC providing means.

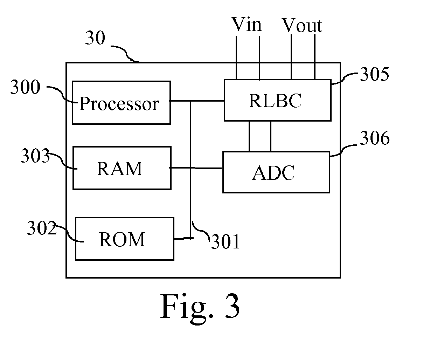

**Fig. 3** represents an example of a device comprising a boost converter composed of plural bridge devices.

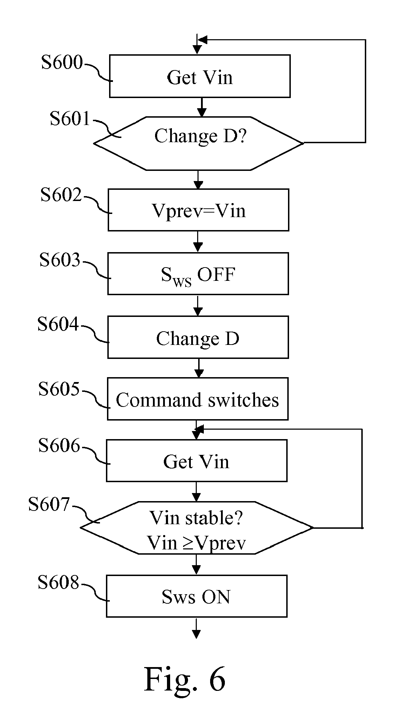

The device 30 has, for example, an architecture based on components connected together by a bus 301 and a processor 300 controlled by the program related to the algorithm as disclosed in the Fig. 6.

It has to be noted here that the device 30 is, in a variant, implemented under the form of one or several dedicated integrated circuits which execute the same operations as the one executed by the processor 300 as disclosed hereinafter.

The bus 301 links the processor 300 to a read only memory ROM 302, a random access memory RAM 303, an analogue to digital converter ADC 306 and the RLBC module as the one disclosed in Fig. 1.

The read only memory ROM 302 contains instructions of the program related to the algorithm as disclosed in the Fig. 6 which are transferred, when the device 30 is powered on to the random access memory RAM 303.

The read only memory ROM 302 memorizes the tables shown in Figs. 4 and 5.

The RAM memory 303 contains registers intended to receive variables, and the instructions of the program related to the algorithm as disclosed in the Fig. 6.

The analogue to digital converter 306 is connected to the RLBC and converts voltages representative of the input voltage Vin and/or the output voltage Vout into binary information.

**Fig. 4** is an example of voltage values on the bridges of the boost converter composed of three bridges in order to have a first step-up ratio when the periodical pattern is decomposed into eight time intervals.

Fig. 4 comprises voltage values on the bridges of the RLBC in order to have a ratio Vout/Vin= 1.14.

In the line 401, a value which is equal to 1 means that Vb1=$V_{ref}$, a value which is equal to -1 means Vb1=-$V_{ref}$ and a value which is equal to 0 means Vb1=0.

In the line 402, a value which is equal to 1 means that Vb2=2$V_{ref}$, a value which is equal to -1 means Vb2=-2$V_{ref}$ and a value which is equal to 0 means Vb2=0.

In the lines 403, a value which is equal to 1 means that Vb3=4$V_{ref}$, a value which is equal to -1 means Vb3=-4$V_{ref}$ and a value which is equal to 0 means Vb3=0.

The duration of each time interval $t_1$ to $t_8$ is $\Delta T=T/N$ (N=8), where T is the duration of the switching cycle operated by switch $S_{33}$ of the Fig. 1.

Eight time intervals are needed in order to get a ratio Vout/Vin= 1.14.

At time interval $t_1$, Vb1=$V_{ref}$, Vb2=2$V_{ref}$ and Vb3=4$V_{ref}$. At time intervals $t_2$, $t_3$, $t_4$ and $t_5$, Vb1=-$V_{ref}$ and Vb2=Vb3=0. At time intervals $t_6$ and $t_7$, Vb1=$V_{ref}$, Vb2=-2$V_{ref}$ and Vb3$_=$0. At time interval $t_8$, Vb1=$V_{ref}$, Vb2=2$V_{ref}$ and Vb3=-4$V_{ref}$.

**Fig. 5** is an example of voltage values on the bridges of the boost converter composed of three bridges in order to have a second step-up ratio when the periodical pattern is decomposed into seven time intervals;

Fig. 5 comprises voltage values on the bridges of the RLBC in order to have a ratio Vout/Vin=1.16.

In the line 501, a value which is equal to 1 means that Vb1=$V_{ref}$, a value which is equal to -1 means Vb1=-$V_{ref}$ and a value which is equal to 0 means Vb1=0.

In the line 502, a value which is equal to 1 means that Vb2=2$V_{ref}$, a value which is equal to -1 means Vb2=-2$V_{ref}$ and a value which is equal to 0 means Vb2=0.

In the line 503, a value which is equal to 1 means that Vb3=4$V_{ref}$, a value which is equal to -1 means Vb3=-4$V_{ref}$ and a value which is equal to 0 means Vb3=0.

The duration of each time interval $t_1$ to $t_7$ is $\Delta T=T/N$ (N=7), where T is the duration of the switching cycle operated by switch $S_{33}$ of the Fig. 1.

Seven time intervals are needed in order to get a ratio Vout/Vin= 1.16.

At time interval T1, Vb1=0, Vb2=2$V_{ref}$ and Vb3=4$V_{ref}$. At time intervals $t_2$, $t_3$ and $t_4$, Vb1=-$V_{ref}$, Vb2=0 and Vb3=0. At time intervals $t_5$ and $t_6$ Vb1=$V_{ref}$, Vb2=-2$V_{ref}$ and Vb3=0. At time interval $t_7$, Vb1=$V_{ref}$, Vb2=2$V_{ref}$ and Vb3=-4$V_{ref}$.

**Fig. 6** is an example of an algorithm for controlling the snubber circuit according to the present invention.

More precisely, the present algorithm is executed by the processor 300 of the device 30.

At step S600, the processor 200 gets the input voltage Vin that the boost converter composed of plural bridge devices has to boost. For example, Vin could be the result of a measurement made by digital converter 306 of the input voltage applied to the boost converter composed of plural bridge devices. As other example, Vin could be determined by computation by processor 300 from yet other measurement made by digital converter 306 of other signals, such as bit voltages, output voltage, input or output currents, so as to realise a specific regulation function. In a special embodiment of the invention, the regulation function is determined so as to maximise the electrical power passing through the boost converter composed of plural bridge devices.

At next step S601, the processor 300 checks the input voltage Vin boosted by the RLBC using a given duty cycle D, for example, the one provided by the periodical pattern corresponding to the table of the Fig. 4.

If the input voltage Vin provides an output voltage value which is comprised in a desired range of output voltage, the processor 300 returns to step S600. Otherwise, the processor 300 moves to step S602.

At step S602, the processor 300 sets the value of the variable Vprev to the value of Vin.

At next step S603, the processor 300 disables the operation of the snubber circuit of the RLBC by transferring a command to the RLBC setting the switch $S_{WS}$ in non conductive state (OFF state).

At next step S604, the processor 300 selects another duty cycle D which enables the boost of the input voltage to an output voltage value which is comprised in the desired range of output voltage. For example, the processor 300 selects the duty cycle D provided by the periodical pattern corresponding to the table of the Fig. 5.

At next step S605, the processor 300 commands the switches of the RLBC 305 according to the pattern stored in memory 302 which corresponds to the duty cycle selected at step S604.

Every time that a change of duty-cycle is necessary, and also during the start-up of the converter, the voltage levels on the different circuit components are not yet under equilibrium. Consequently, undesirable voltage will appear on the snubber resistor if the switch $S_{WS}$ is not in non conductive state (OFF) and the voltage on the snubber capacitor will be higher than the input voltage imposed by the RLBC converter. That will result in current peaks through the resistor and capacitor of the snubber circuit and consequently through the RLBC circuit, since the snubber current will add to the current coming from the electric power providing means like photovoltaic module.

Before achieving the equilibrium with the second periodical pattern, there could be a maximum peak current in the resistor $R_S$ equal to Vout/(8*Rs), for this particular case described here according to Figs 1, 4 and 5.

Thanks to the invention, this current is not generated.

At next step S606, the processor 300 gets the input voltage Vin that the boost converter composed of plural bridge devices has to boost as disclosed at step S600.

At next step S607, the processor 300 checks if the voltage Vin is compatible with a given value.

The voltage Vin is compatible with a given value if Vin is stable and if the transient variations due to the duty-cycle change is over.

The voltage Vin is stable when variations around its average value is plus or minus five percent. The stability of Vin is checked by means of a moving average calculation using all the points available during every single switching period. When the difference between two consecutive average calculations is smaller than five percent, the stability is reached.

If the voltage Vin is not compatible with the given value, the processor 300 returns to step S606.

If the voltage Vin is stable but Vin is less than the memorized value Vprev, the processor 300 also returns to step S606.

If the voltage Vin is stable and greater or equal Vprev, the processor 300 moves to step S608.

At next step S608, the processor 300 enables to operation of the snubber circuit of the RLBC by transferring a command to the RLBC setting the switch $S_{WS}$ in the conductive state (ON state).

After that, the processor 300 returns to step S600.

It has to be noted here that when the RLBC is powered on or when the RLCB is resetted in initial conditions, the processor 300 enables to operation of the snubber circuit of the RLBC only when Vin is stable as explained in step S607. The stability of Vin is checked by means of a moving average calculation using all the points available during every single switching period. The snubber capacitor is completely or almost completely discharged in such situations.

When the difference between two consecutive average calculations is smaller than five percent, the stability is reached. At this point the snubber circuit can be enabled ($S_{SW}$ in ON state) without any other concern. The current that will flow through the capacitor $C_S$ is limited to $I_{SC}$, Vin is equal to $V_{OC}$, the photovoltaic module open-circuit voltage, which is also the same voltage applied by the RLBC circuit to the input. Vin is greater than the initial Vprev=0 since the switch $S_{SW}$ is open during the start-up).

Naturally, many modifications can be made to the embodiments of the invention described above without departing from the scope of the present invention.

**Claims**

1. Apparatus for controlling the operation of a snubber circuit in a system in which an input voltage is processed using at least switches controlled with at least one periodical pattern, **characterised in that** the input voltage is applied to the snubber circuit when the operation of the snubber circuit is enabled, and **in that** the apparatus comprises:

   - means for determining a periodical pattern to be used for controlling the switches, the periodical pattern modifying the input voltage,
   - means for disabling the operation of the snubber circuit,
   - means for controlling the switches with the determined periodical pattern,
   - means for checking if the input voltage is compatible with a given value,
   - means for enabling the operation of the snubber circuit when the input voltage is compatible with the given value.

2. Apparatus according to claim 1, **characterised in that** the switches used for processing the input voltage are switches of a boost converter composed of plural bridge devices.

3. Apparatus according to claim 1 or 2, **characterised in that** the means for enabling/disabling the operation of the snubber circuit are composed of a switch.

4. Apparatus according to claim 1 or 2, **characterised in that** the means for enabling/disabling the operation of the snubber circuit are composed of two N-MOSFET transistors and their respective body diodes.

5. Apparatus according to any of the claims 1 to 4, **characterised in that** the snubber circuit is composed of a capacitor connected in series with a sub-circuit composed of a resistor and a diode connected in parallel.

6. Method for controlling the operation of a snubber circuit in a system in which an input voltage is processed using at least switches using at least one periodical pattern, **characterised in that** the input voltage is applied to the snubber circuit when the operation of the snubber circuit is enabled, and **in that** the method comprises the steps of:

- determining a periodical pattern to be used for controlling the switches, the periodical pattern modifying the input voltage,
- disabling the operation of the snubber circuit,
- controlling the switches with the determined periodical pattern,
- checking if the input voltage is compatible with a given value,
- enabling the operation of the snubber circuit when the input voltage is compatible with the given value.

Fig. 1

Fig. 2

Fig. 3

| P=1 N=8 D=0.125 $V_{ref}$ = Vout/8 | Time interval | | | | | | | |
|---|---|---|---|---|---|---|---|---|
| | $t_1$ | $t_2$ | $t_3$ | $t_4$ | $t_5$ | $t_6$ | $t_7$ | $t_8$ |
| Vc1= $V_{ref}$ | 1 | -1 | -1 | -1 | -1 | 1 | 1 | 1 |
| Vc2=2$V_{ref}$ | 1 | 0 | 0 | 0 | 0 | -1 | -1 | 1 |
| Vc3= 4$V_{ref}$ | 1 | 0 | 0 | 0 | 0 | 0 | 0 | -1 |

401
402
433

# Fig. 4

| P=1 N=7 D=0.142 $V_{ref}$ = Vout/7 | Time interval | | | | | | |
|---|---|---|---|---|---|---|---|
| | $t_1$ | $t_2$ | $t_3$ | $t_4$ | $t_5$ | $t_6$ | $t_7$ |
| Vc1= $V_{ref}$ | 0 | -1 | -1 | -1 | 1 | 1 | 1 |
| Vc2=2$V_{ref}$ | 1 | 0 | 0 | 0 | -1 | -1 | 1 |
| Vc3= 4$V_{ref}$ | 1 | 0 | 0 | 0 | 0 | 0 | -1 |

501
502
503

# Fig. 5

S600 — Get Vin

S601 — Change D?

S602 — Vprev=Vin

S603 — $S_{WS}$ OFF

S604 — Change D

S605 — Command switches

S606 — Get Vin

S607 — Vin stable?
Vin ≥Vprev

S608 — Sws ON

# Fig. 6

Europäisches
Patentamt

European
Patent Office

Office européen
des brevets

**EUROPEAN SEARCH REPORT**

Application Number

EP 09 15 8624

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 556 462 B1 (STEIGERWALD ROBERT LOUIS [US] ET AL) 29 April 2003 (2003-04-29) * column 1, line 12 - column 5, line 25; figures 1,2 * ----- | 1-6 | INV. H03K17/082 H02M5/458 H02M7/217 |
| A | US 6 002 241 A (JACOBS MARK E [US] ET AL) 14 December 1999 (1999-12-14) * column 1, line 51 - column 6, line 27; figures 1-4 * ----- | 1-6 | |
| A | WO 00/15013 A2 (ELECTRO MAG INT INC [US]) 16 March 2000 (2000-03-16) * page 1, line 15 - page 4, line 29; figures 1-6 * * page 6, line 2 - page 11, line 29 * ----- | 1-6 | |
| | | | TECHNICAL FIELDS SEARCHED (IPC) |
| | | | H03K H02M |

The present search report has been drawn up for all claims

| Place of search | Date of completion of the search | Examiner |
|---|---|---|
| Munich | 23 November 2009 | Kassner, Holger |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................................
& : member of the same patent family, corresponding
document

EPO FORM 1503 03.82 (P04C01)

**ANNEX TO THE EUROPEAN SEARCH REPORT**
**ON EUROPEAN PATENT APPLICATION NO.**                    EP 09 15 8624

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2009

| Patent document cited in search report | | Publication date | Patent family member(s) | | Publication date |
|---|---|---|---|---|---|
| US 6556462 | B1 | 29-04-2003 | DE | 10329064 A1 | 05-02-2004 |
| | | | FR | 2845211 A1 | 02-04-2004 |
| | | | JP | 2004056997 A | 19-02-2004 |
| US 6002241 | A | 14-12-1999 | NONE | | |
| WO 0015013 | A2 | 16-03-2000 | AU | 5808199 A | 27-03-2000 |
| | | | CA | 2342905 A1 | 16-03-2000 |
| | | | EP | 1118253 A2 | 25-07-2001 |

EPO FORM P0459

For more details about this annex : see Official Journal of the European Patent Office, No. 12/82